# EUROPEAN PATENT APPLICATION

(11) **EP 1 909 279 A1**
(43) Date of publication of application: **09.04.2008**
(21) Application number: 07106873.8
(22) Date of filing: 24.04.2007
(51) Int. Cl.: G11B 20/10, G11B 20/14, H04L 7/033, H03L 7/06

(54) **Clock extraction method for patterned medium and circuit thereof**

(30) Priority: 26.09.2006 JP 2006261582
(71) Applicant: FUJITSU LIMITED, Kawasaki-shi, Kanagawa 211-8588 (JP)
(72) Inventor: Izumi, Haruhiko c/o FUJITSU LIMITED, Kawasaki-shi, Kanagawa 211-8588 (JP)
(74) Representative: Wilding, Frances Ward

(57) **Abstract**

Aimed at is to match a timing of a clock signal with a magnetic dot of a patterned medium. A point at which an amplitude of a reproduction waveform becomes zero or a point at which an amplitude of a magnetic signal changes from the positive to negative or from the negative to positive is detected(22), and a zero level detection signal or zero-cross detection signal is output to a clock generation circuit(23) which then synchronizes a clock signal with the zero level detection signal or zero-cross detection signal. This enables a matching of the clock signal with a magnetic dot.

## Description

### Background of the Invention

### Field of the Invention

The present invention relates to a clock extraction method for a patterned medium, and to a circuit and a disk apparatus which extract a clock from a patterned medium.

### Description of the Related Art

A patterned medium having a magnetic dot pattern corresponding to a data bit possesses a characteristic of increasing a recording density than a hard disk which is structured by a magnetic continuous film.

A patterned medium needs to form magnetic dots at certain intervals, also requiring the surface of the magnetic dots to be flat so that the magnetic dots are flush with the surface of a substrate of the medium. This has conventionally necessitated a grinding process called a chemical mechanical grinding at the end of a production process of the media, thereby making the surface thereof flat.

A patent document 1 notes a method for omitting the chemical mechanical grinding process in a production process of a patterned medium, summarizing the process as follows:
(a) Make a matrix thin film having a role of a matrix surrounding magnetic bits intervene between a glass substrate and a resist film. A thickness of the matrix thin film is adjusted to a requirement of a magnetic bit;
(b) Apply an electron ray exposure along with a bit pattern, followed by applying a development process for forming a patterned mask;
(c) Transfer the bit array pattern to the matrix thin film by applying a reactive ion etching. Apply the etching until the surface of the substrate is exposed;
(d) Form a magnetic thin film by a vacuum deposition, et cetera. The thickness is desirably adjusted exactly to a depth of a trench array carved in the matrix thin film;
(e) Remove the patterned mask by melting it by using an organic solvent, resulting in forming a magnetic bit array having a flat surface; and
(f) Cover the surface with a surface lubrication layer for protecting it.

At a magnetic disk apparatus, a data reading and writing is carried out synchronously with a clock signal. In a patterned medium, a position of a magnetic dot for recording data is fixed and therefore a clock signal needs to be matched with the position of the magnetic dot.

Conventionally, however, a method for matching a clock signal with the position of the magnetic dot has not been accomplished for a magnetic disk apparatus using a patterned medium.

[Patent document 1] Laid-Open Japanese Patent Application Publication No. 2001-110050

### Summary of the Invention

The subject of the present invention is to match a timing of a clock signal with a position of a magnetic dot of a patterned medium.

The present invention is a clock extraction method for extracting a clock signal determining a timing of writing or reading data to or from a patterned medium, comprising: detecting by using a magnetism detection unit a magnetic signal recorded in a patterned medium arraying magnetic dots in certain intervals for recording the magnetic signal; detecting a timing at which an absolute value of an amplitude of the magnetic signal detected by the magnetism detection unit is equal to or smaller than a certain value; and synchronizing the clock signal with the timing.

This invention synchronizes a clock signal with a timing at which the amplitude of a magnetic signal is equal to or smaller than a certain value, thereby making it possible to synchronize the clock signal with the timing of a nonmagnetic part between magnetic dots being detected. Synchronizing the clock signal with the nonmagnetic part makes it possible to synchronize the clock signal with a position of a magnetic dot because a position of a zero level of the nonmagnetic part being detected is determined by a center distance between the magnetic dots. Therefore, writing or reading data at the timing of synchronizing with the clock signal enables a data writing or reading at the position of a magnetic dot of the patterned medium.

The clock extraction method of a patterned medium according to the invention detects a timing at which the amplitude of the magnetic signal indicates a value within a certain range with zero at the center thereof as a timing at which an absolute value of the amplitude indicates a certain value or smaller.

This configuration makes it possible to detect a timing at which the amplitude of the magnetic signal is equal to or smaller than a positive reference value, or it is equal to or larger than a negative reference value as a zero level of the amplitude.
Another clock extraction method according to the present invention is one for extracting a clock signal determining a timing of writing or reading data to or from a patterned medium, comprising: detecting by using a magnetism detection unit a magnetic signal recorded in a patterned medium arraying magnetic dots at certain intervals for recording the magnetic signal; detecting a zero-cross point at which an amplitude of the magnetic signal detected by the magnetism detection unit changes from the positive to negative, or from the negative to positive; and synchronizing the clock signal with the zero-cross point.

This invention synchronizes a clock signal with the zero-cross point of the amplitude of a magnetic signal, thereby enabling a synchronization of the clock signal with the zero-cross point of the nonmagnetic part. A position of the zero-cross point of the nonmagnetic part is determined by a center distance of magnetic dots and accordingly the clock signal can be synchronized with the magnetic dot by synchronizing the clock signal with the zero cross point in the nonmagnetic part. Therefore, writing or reading data at a timing synchronized with the clock signal enables a data writing or reading at a position of a magnetic dot of the patterned media.

The clock extraction method of a patterned medium according to the invention supplies a phase locked loop (PLL) circuit generating the clock signal with a zero-cross detection signal indicating the zero-cross point as a reference signal, and synchronizing the clock signal with the zero-cross detection signal.

This configuration enables synchronization of a clock signal generated by the PLL circuit with a zero-cross detection signal. This in turn makes it possible to match the timing of a clock signal with a position of a magnetic dot.

The clock extraction method of a patterned medium according to the invention sets a wavelength of the clock signal equal to a center distance of the magnetic dots.

This configuration makes it possible to synchronize a clock signal with the center position of a magnetic dot when synchronizing the clock signal with a timing of a nonmagnetic part being detected.

A clock extraction circuit for a patterned medium according to the present invention comprises: a clock signal generation circuit for generating a clock signal determining a timing of writing or reading data to or from a patterned medium; a magnetism detection unit for detecting a magnetic signal recorded in a patterned medium arraying magnetic dots at certain intervals for recording the magnetic signal; and a zero level detection circuit for detecting a zero level at which an absolute value of an amplitude of the magnetic signal detected by the magnetism detection unit indicates a certain value or smaller, wherein the clock signal is synchronized with the timing of the zero level being detected.

This invention enables a synchronization of a clock signal with the timing of a zero level of the nonmagnetic part between magnetic dots being detected. A point of a nonmagnetic part indicating a zero level is determined by the center distance of magnetic dots and therefore clock signal can be synchronized with the magnetic dot by synchronizing the clock signal with the timing of the zero level of the nonmagnetic part being detected. Therefore, writing or reading data at a timing synchronized with the clock signal enables a data writing or reading at a position of a magnetic dot of the patterned media.

In the clock extraction circuit according to the present invention, the zero level detection circuit comprises a first comparator for judging whether or not an amplitude of the magnetic signal is equal to or smaller than a positive reference value, a second comparator for judging whether or not the amplitude of the magnetic signal is equal to or larger than a negative reference value, and an output circuit for outputting a zero level detection signal to the clock signal generation circuit if the first and second comparators respectively judge that the amplitude is equal to or smaller than the positive reference value and also equal to or larger than the negative reference value.

This configuration makes it possible to detect a zero level in which the amplitude of a magnetic signal indicates a value within a certain range with a zero at the center, thereby synchronizing a clock signal with a timing of the zero level of a nonmagnetic part being detected.

Another clock extraction circuit for a patterned medium according to the present invention comprises: a clock signal generation circuit for generating a clock signal determining a timing of writing or reading data to or from a patterned medium; a magnetism detection unit for detecting a magnetic signal recorded in a patterned medium arraying magnetic dots at certain intervals for recording the magnetic signal; and a zero-cross detection circuit for detecting a zero-cross point at which an amplitude of the magnetic signal detected by the magnetism detection unit changes from the positive to negative, or from the negative to positive, wherein the clock signal is synchronized with the zero-cross point.

This invention synchronizes a clock signal with a zero-cross point of the amplitude of a magnetic signal, thereby enabling synchronization of the clock signal with a timing of a nonmagnetic part being detected. The zero-cross point of the nonmagnetic part is determined by a center distance of magnetic dots and accordingly a timing of the clock signal can be synchronized with the timing of the magnetic dot being detected.

In the clock extraction circuit according to the present invention, the zero-cross detection circuit comprises a first comparator for detecting whether or not an amplitude of the magnetic signal changes from the positive to negative, a first signal generation circuit for generating a signal triggered by an output signal of the first comparator, a second comparator for detecting whether or not the amplitude of the magnetic signal changes from the negative to positive, a second signal generation circuit for generating a signal triggered by an output signal of the second comparator, and an output circuit for outputting, to the clock signal generation circuit, the output signal of the first signal generation circuit and that of the second signal generation circuit as the zero-cross detection signals indicating the zero-cross point.

This configuration makes it possible to detect a zero-cross point of a nonmagnetic part by using the first and second comparators.
In the clock extraction circuit according to the present invention, the clock signal generation circuit is a phase locked loop (PLL) circuit comprising at least a voltage-controlled oscillator, a division circuit and a phase comparator, wherein the phase comparator supplies the voltage-controlled oscillator with a control voltage corresponding to a phase difference between the zero level detection signal or zero-cross detection signal and the clock signal, and synchronize the clock signal with the zero level detection signal or zero-cross detection signal.

This configuration enables a matching of a timing of a clock signal with a magnetic dot.

### Brief Description of the Drawings

Fig. 1 is a diagram showing a structure of a patterned medium according to a preferred embodiment;
Fig. 2 is a circuit diagram of a clock extraction circuit according to a first embodiment;
Fig. 3 is a circuit diagram of a zero level detection circuit;
Fig. 4 is a circuit diagram of a PLL circuit;
Fig. 5 is a diagram describing a clock extraction method according to the first embodiment;
Fig. 6 is a circuit diagram of a clock extraction circuit according to a second embodiment; and
Fig. 7 is a circuit diagram of a zero-cross detection circuit.

### Description of the Preferred Embodiments

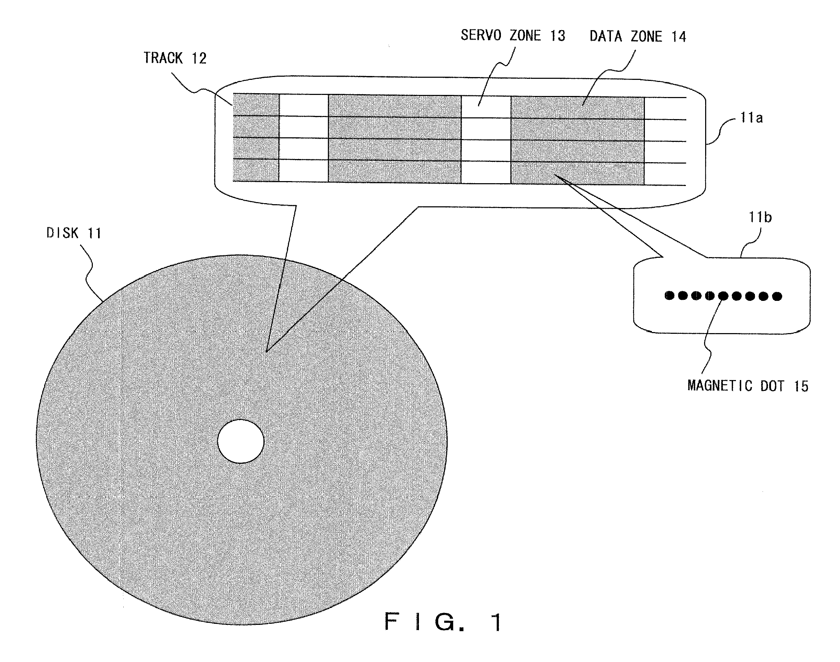

The following is a description of the preferred embodiments of the present invention by referring to the accompanying drawings. Fig. 1 is a diagram showing a structure of a patterned medium 11 according to a first embodiment.

Fig. 1 shows the patterned medium 11 and its partial enlargement diagram 11a and a partial enlargement diagram 11b of a data zone 14. The patterned medium (i.e., a disk) 11 is featured with a plurality of tracks 12 in a concentric circular pattern with each track 12 being arrayed, at constant intervals, with servo zones 13 recording data used for controlling positions of writing and reading data, and data zones 14 for recording the data.

Magnetic dots 15 for recording a magnetic signal are arrayed at certain intervals in the data zone 14. Note that a production method for the patterned medium 11 can use a conventional production method.

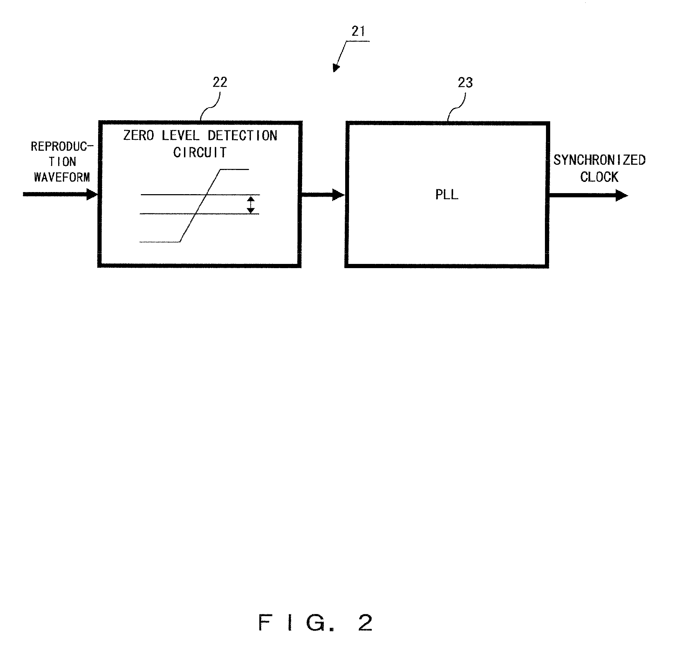

Fig. 2 is a circuit diagram of a clock extraction circuit 21 according to a first embodiment. The clock extraction circuit 21 comprises a zero level detection circuit 22 and a phase locked loop (PLL) circuit (corresponding to a clock signal generation circuit) 23. The clock extraction circuit 21 is built-in in a magnetic disk apparatus of which other circuit configurations are the same as those of a common hard disk apparatus.

The magnetic disk apparatus comprises a magnetic head (corresponding to a magnetism detection unit) comprising a magnetic sensor for writing or reading data. The magnetic head detects a magnetic signal recorded in the patterned medium 11 and converts it into an electric signal.

The zero level detection circuit 22 is a circuit for detecting whether or not an amplitude of an output signal of the magnetic head (which is called a reproduction waveform) is within a certain range determined by a positive certain value and a negative certain value with "0" at the center. The zero level detection circuit 22 outputs a high level signal when the amplitude of the reproduction waveform is equal to or smaller than the positive certain value and also it is equal to or larger than the negative certain value, and outputs a low level signal in other times, both as zero level detection signal.

The PLL circuit 24, being a circuit for generating a clock signal determining a timing of writing and reading data, is constituted by a voltage controlled oscillator, division circuit, phase comparator and such, and performs a phase control for synchronizing an oscillation signal generated by the voltage controlled oscillator with a reference signal.

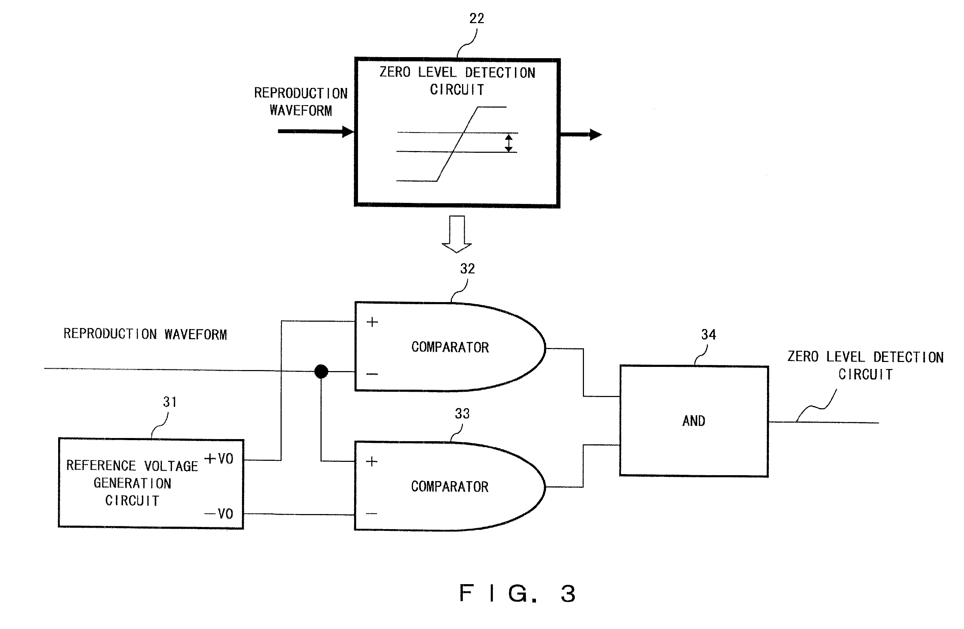

Fig. 3 shows an example of a circuit diagram of a zero level detection circuit 22 which comprises a reference voltage generation circuit 31, comparators 32 and 33, and an AND gate 34.

The reference voltage generation circuit 31 generates a positive reference voltage of +V0 which is slightly higher than the ground level, and a negative reference voltage of -V0 which is slightly lower than the ground level. The voltage range determined by the positive reference voltage of +V0 and negative reference voltage of -V0 is a zero level detection range of the amplitude of a reproduction waveform.

A reproduction waveform is input to an inversion input terminal of the comparator 32, and the positive reference voltage of +V0 is input to a non-inversion input terminal thereof. The comparator 32 compares the reproduction waveform with the positive reference voltage of +V0 and outputs a low level signal if the amplitude of the reproduction waveform is larger than the positive reference voltage of +V0, and a high level signal when that of the reproduction waveform is equal to or smaller than the positive reference signal of +V0. The comparator 32 corresponds to a first comparator for judging whether the amplitude is equal to or smaller than the positive reference value.

A reproduction waveform is input to a non-inversion input terminal of the comparator 33, and the negative reference voltage of -V0 is input to an inversion input terminal thereof. The comparator 33 compares the reproduction waveform with the negative reference voltage of -V0 and outputs a high level signal if the amplitude of the reproduction waveform is equal to or larger than the negative reference voltage of -V0, and outputs a low level signal if that of the reproduction waveform is smaller than the negative reference voltage of -V0. The comparator 33 corresponds to a second comparator for judging whether or not the amplitude is equal to or larger than a negative reference voltage.

The AND gate (corresponding to an output circuit) 34 outputs a signal as a result of obtaining a logic product of respective outputs of the comparators 32 and 33 as a zero level detection signal. Therefore, the AND gate 34 outputs a signal, as a zero level detection signal, being a high level signal if the amplitude of the reproduction waveform is equal to or smaller than the positive reference voltage of +V0 and also equal to or larger than the negative reference voltage of -V0, while being a low level if the amplitude of the reproduction waveform is larger than the positive reference voltage of +V0 or smaller than the negative reference voltage of -V0.

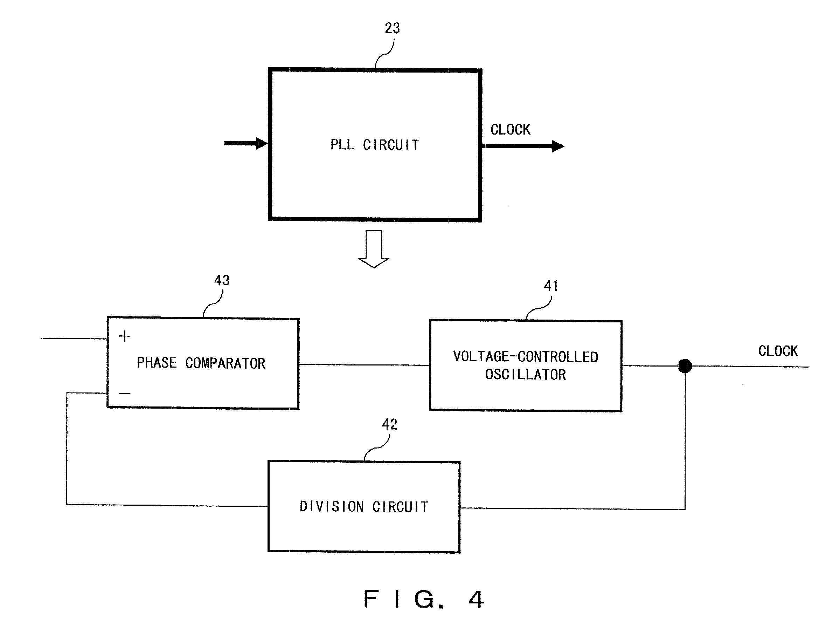

Fig. 4 is a circuit diagram of a common PLL circuit 23. The PLL circuit 23 comprises a voltage-controlled oscillator 41, a division circuit 42, and a phase comparator 43.

The division circuit 42 divides an oscillation signal of the voltage-controlled oscillator 41 and outputs the divided signal to the phase comparator 43. The phase comparator 43, being provided with a zero level detection signal output from the zero level detection circuit 22 as a reference signal, detects a phase difference between the zero level detection signal and the signal divided by the division circuit 42, and outputs to the voltage-controlled oscillator 41 a control voltage corresponding to an advance or delay of the phase. The voltage-controlled oscillator 41 oscillates and emits a signal of a frequency in response to the control voltage.

With a repetition of the above described operation at the PLL circuit 23, a clock signal synchronized with the zero-cross detection signal is output from the voltage-controlled oscillator 41. A rise timing of the zero level detection signal matches approximately with the center position of a nonmagnetic part between magnetic dots 15, and therefore the position of a magnetic dot 15 can be matched with a rise timing (or fall timing) of a clock signal by synchronizing a rise of the clock signal with a rise timing of the zero level detection signal. Note that a wavelength of a clock signal, for example, needs to be set at a 1/n or n times (where "n" is a natural number) of the center distance between adjacent dots 15 as a premise for a timing of a clock signal matching with the center position of a magnetic dot. The present preferred embodiment is configured to set the wavelength of the clock signal equal to the center distance between magnetic dots 15.

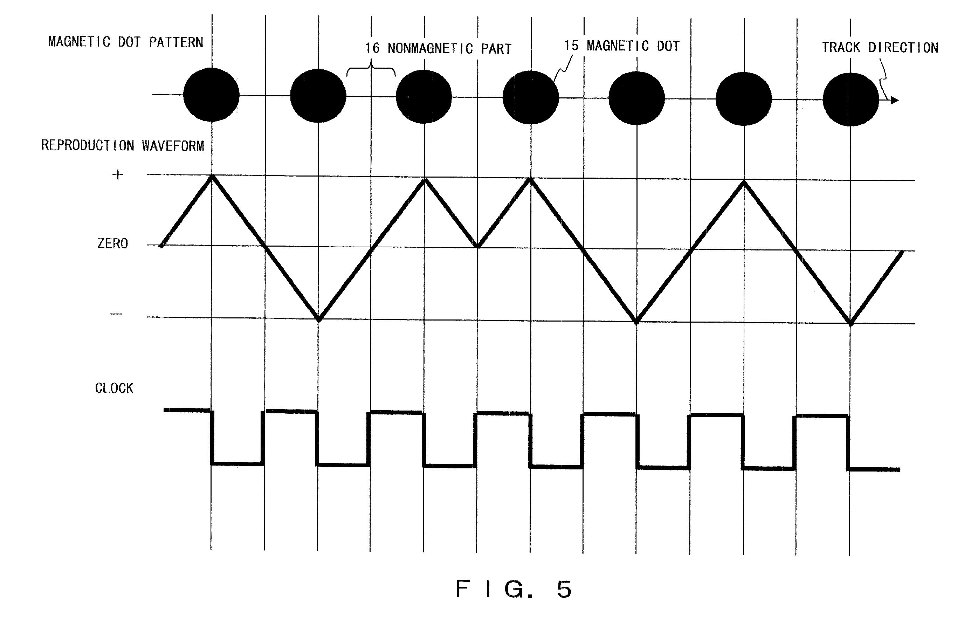

Here, the description is of a clock extraction method according to the first embodiment by referring to Fig. 5. Fig. 5 is a diagram showing a magnetic dot pattern indicating an array of magnetic dots 15 of a patterned medium 11, a reproduction waveform of a magnetic signal recorded in the dots 15 and a clock signal. The horizontal arrow of the magnetic dot pattern shown in Fig. 5 indicates the track direction of the patterned medium 11.

The present embodiment is configured to magnetize the magnetic dot 15 to have a positive or negative pole corresponding to data of "1" or "0", and record data by further coding it by a (1, 7) RLL (Run-length limiting) that is a run-length limiting code. Using the run-length limiting code prevents the magnetic dots 15 from being magnetized to have the same pole continuously for more than a certain number, and therefore it is possible to detect accurately a zero level where the amplitude of a magnetic signal between a magnetic dot 15 magnetized to have the positive pole and one magnetized to have the negative pole becomes zero. Incidentally a code other than the run-length limiting code may be used.

The reproduction waveform shown in Fig. 5 shows a signal waveform in the case of the magnetic dot 15 on the leftmost (viewed from the front of Fig. 5; the same definition hereinafter) being magnetized to be the positive pole, the adjacent magnetic dot 15 on the second from the left being magnetized to be the negative pole, the two magnetic dots 15 on the third and fourth being magnetized to be the same positive pole, the right adjacent magnetic dot 15 being magnetized to be the negative pole and the right adjacent magnetic dot 15 being magnetized to be the positive pole.

A reproduction waveform of a magnetic signal detected by a magnetic head by rotating the patterned medium 11 with the magnetic dot 15 having been magnetized as described above indicates that the amplitude points at the positive or negative peak at the center positions of the magnetic dot 15 and becomes approximately zero at the center positions of the nonmagnetic parts 16 as shown in Fig. 5.

Detecting a zero level of the reproduction waveform by using the zero level detection circuit 22, the amplitude of the reproduction waveform is equal to or smaller than the positive reference voltage of +V0 or equal to or larger than the negative reference voltage of -V0 nearby the center of the nonmagnetic part 16 between magnetic dots 15, during which time a zero level detection signal of a high level is output.

Supplying the PLL circuit 23 with the above described zero level detection signal as a reference signal makes it possible to synchronize a clock signal of the PLL circuit 23 with a rise timing of the zero level detection signal, that is, a timing of the center position of the nonmagnetic part 16 being detected.

When setting one cycle of a clock signal, for example, equal to a time period from a peak value of a magnetic signal of one magnetic dot 15 being detected until a time of a peak value of the next magnetic dot 15 being detected(i.e., a time determined by a rotating speed and the center distance between adjacent dots 15), a rise (or fall) of the clock signal can be synchronized with a timing of the magnetic dot 15 being detected by synchronizing the rise (or fall) of the clock signal with a rise (or fall) of the zero level detection signal. Note that, when rotating the patterned medium 11 at a certain rpm (revolutions per minute), the rotation speeds are different between the outer and inner circumferences, and therefore the patterned medium 11 is divided into a plurality of zones in the radial direction and the frequency of a clock signal is changed for each of the zones.

The above described first embodiment is configured to detect the position of a nonmagnetic part 16 in which a magnetic dot 15 does not exist by detecting a magnetic signal and synchronize a clock signal with the detected signal (i.e., the zero level detection signal), thereby making it possible to synchronize the clock signal with the timing of the center position of the nonmagnetic part 16 being detected in the case of writing or reading data by rotating the patterned medium 11.

Therefore, writing and reading data at the timing synchronized with the clock signal enable the data writing and reading accurately at the position at which a magnetic dot 15 of the patterned medium 11 exists.

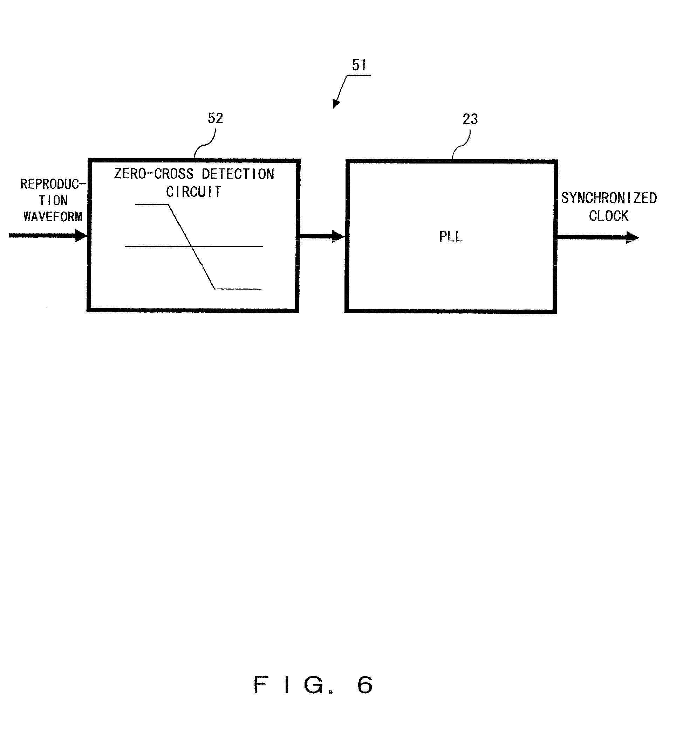

Next, Fig. 6 is a block diagram of a clock extraction circuit 51 according to a second embodiment.

The clock extraction circuit 51 comprises a zero-cross detection circuit 52 and a PLL circuit 23. The PLL circuit 23 is configured to be the same as the circuit shown in Fig. 4.

The zero-cross detection circuit 52 is one for detecting a zero-cross point at which the amplitude of a reproduction waveform changes from a positive value to a negative value, or from the negative to positive.

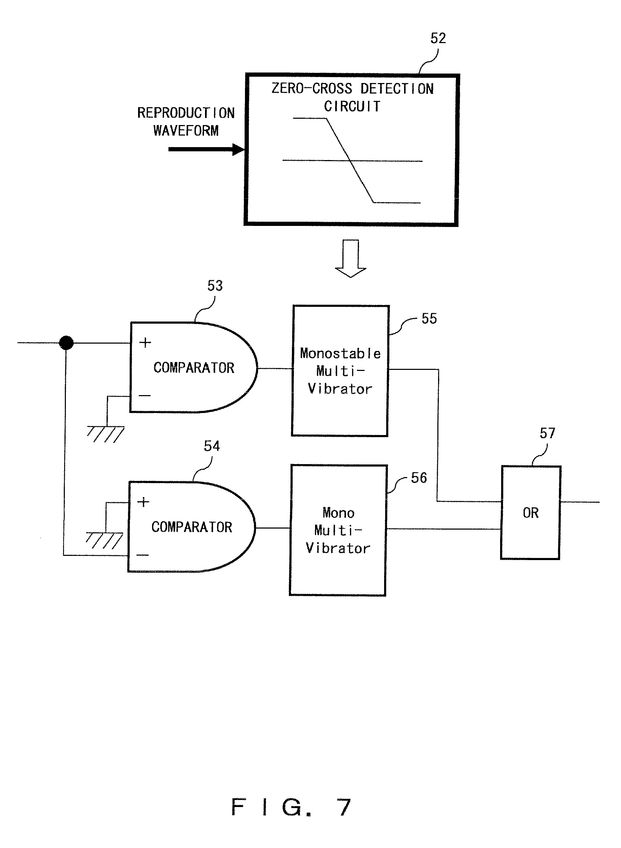

Fig. 7 is a circuit diagram of the zero-cross detection circuit 52. The zero-cross detection circuit 52 is constituted by comparators 53 and 54, monostable multi-vibrators 55 and 56, and an OR gate 57.

A reproduction waveform is input to a non-inversion input terminal of the comparator 53 and an inversion input terminal thereof is grounded. The comparator 53 compares the amplitude of the reproduction waveform with the ground level and outputs a low level signal if the amplitude of the reproduction waveform is smaller than the ground level, and outputs a high level signal if the amplitude of the reproduction waveform is equal to or larger than the ground level. Therefore, an output signal of the comparator 53 changes from the low level to high level when the amplitude of a reproduction waveform changes from a negative value to a positive value (i.e. , to the ground level or larger) .

The monostable multi-vibrator 55 outputs a pulse of a certain width at a rise of an output signal of the comparator 53 as a trigger.

The comparator 53 and monostable multi-vibrator 55 constitute a circuit for generating a pulse signal synchronized with a zero-cross point at which the amplitude of a reproduction waveform changes from a negative value to a positive value.

A reproduction waveform is input to an inversion input terminal of the comparator 54 and a non-inversion input terminal thereof is grounded. The comparator 54 compares the amplitude of the reproduction waveform with the ground voltage and outputs a low level signal if the amplitude of the reproduction waveform is equal to or larger than the ground voltage, and outputs a high level signal if the amplitude is negative. Therefore, an output signal of the comparator 54 changes from the low level to high level when the amplitude of a reproduction waveform changes from a positive value to a negative value of being lower than the ground voltage.

The monostable multi-vibrator 56 outputs a pulse of a certain width at a rise of an output signal of the comparator 54 as trigger.

The comparator 54 and monostable multi-vibrator 56 constitute a circuit for generating a pulse signal synchronized with a zero-cross point at which the amplitude of a reproduction waveform changes from a positive value to a negative value.

The OR gate (corresponding to an output circuit) 57 outputs a logic sum of an output of the monostable multi-vibrator 55 and that of the monostable multi-vibrator 56. A signal output from the OR gate 57 is called a zero-cross detection signal hereinafter.

Therefore, the monostable multi-vibrators 55 and 56 each outputs a pulse signal of a certain width at a timing synchronized with a zero-cross point at which the amplitude of the reproduction waveform crosses zero from the negative value and the amplitude crosses zero from the positive value, respectively. The pulse signal is supplied to the PLL circuit 23 as a reference signal.

At this point, a description is of a clock extraction method according to the second embodiment by referring to Fig. 5 which is already used for describing the first embodiment.

Supposing that the amplitude of a reproduction waveform of the left most magnetic dot 15 as shown in Fig. 5 indicates a positive peak value and that the amplitude of a reproduction waveform of the second magnetic dot 15 indicates a negative peak value, then the amplitude of the reproduction waveform changes from the positive to negative values at the center position of the nonmagnetic part 16 between the first and second magnetic dots 15. When the amplitude of the reproduction waveform changes from the positive to negative values, the comparator shown in Fig. 7 detects a zero-cross point at which the amplitude of the reproduction waveform changes from the positive to negative, and the output signal accordingly changes from a low level to a high level. And the monostable multi-vibrators 56 outputs a pulse signal of a certain width triggered by a rise of an output signal of the comparator 54. The pulse signal is output from the OR gate 57 to the PLL circuit 23 as a zero-cross detection signal. The PLL circuit 23 synchronizes a clock signal with the rise of the zero-cross detection signal, thereby making it possible to generate the clock signal rising at the zero-cross point of the reproduction waveform as shown in Fig. 5.

Next, supposing that the reproduction waveform of the second magnetic dot 15 from the left indicates a negative peak value and that the reproduction waveform of the third magnetic dot 15 indicates a positive peak value, then the amplitude of the reproduction waveform changes from the negative to positive at the center position of the nonmagnetic part 16 between the second and third magnetic dots 15. When the amplitude of the reproduction waveform changes from the negative to positive values, the comparator 53 shown in Fig. 7 detects a zero-cross point at which the amplitude of the reproduction waveform changes from the negative to positive, and the output signal of the comparator 53 changes from a low level to a high level. Then the monostable multi-vibrators 55 outputs a pulse signal of a certain width triggered by a rise of an output signal of the comparator 53. The pulse signal is output to the PLL circuit 23 as a zero-cross detection signal. The PLL circuit 23 synchronizes a clock signal generated by the voltage-controlled oscillator 41 with a rise of the zero-cross detection signal, thereby making it possible to synchronize the clock signal with the zero-cross point of the amplitude of the reproduction waveform.

The above described second embodiment is configured to detect a zero-cross point of the amplitude of a reproduction waveform of the nonmagnetic part 16 and synchronize a clock signal with the zero-cross point, thereby making it possible to synchronize the clock signal with the center position of the nonmagnetic part 16. Setting a wavelength of the clock signal, for example, equal to the center distance between magnetic dots 15 enables a synchronization of a timing of the clock signal with the position of the magnetic dot 15.

Therefore, writing or reading data at a timing synchronized with the clock signal enables a data writing or reading accurately at the position of a magnetic dot 15 of the patterned medium 11.

Furthermore, the second embodiment is configured to detect a zero-cross point of a reproduction waveform, and therefore detection accuracy can be improved in the case of detecting a point at which the amplitude of the reproduction waveform indicates approximately zero. If a signal level of a detected magnetic signal is, for example, very low, a position of the amplitude indicating zero level may not possibly be identical with the center position of a nonmagnetic part 16; the clock extraction method according to the second embodiment, however, is capable of detecting the zero-cross point of the amplitude, that is, the center position of the nonmagnetic part 16 more accurately because of detecting the zero-cross point at which the reproduction waveform of the nonmagnetic part 16 changes from the positive to negative, or from the negative to positive.

The second embodiment is configured to detect a zero-cross point at which the amplitude of a reproduction waveform changes from the positive to negative, or from the negative to positive, and therefore a run-length limiting coding for limiting the same pole from continuing for a certain number is preferable; it is, however, possible to accomplish it without using a run-length limiting coding.

The above described preferred embodiments are capable of matching the timing of a clock signal with a magnetic dot of the patterned medium, thereby enabling a data writing or reading matching with the position of the magnetic dot.

In lieu of being limited to the preferred embodiments described above, the present invention may be, as an example, contrived as follows:
A circuit for detecting the nonmagnetic part 16 may use another analog circuit or a digital circuit by converting the reproduction waveform from analog to digital (A/D) to detect a zero level or zero-cross point, in lieu of being limited to using the analog circuits of the zero level detection circuit 22 and zero-cross detection circuit 53 and the like described for the embodiments.

## Claims

1. A clock extraction method for extracting a clock signal determining a timing of writing or reading data to or from a patterned medium, comprising:
detecting by using a magnetism detection unit a magnetic signal recorded in the patterned medium arraying magnetic dots at certain intervals for recording the magnetic signal;
detecting a timing at which an absolute value of an amplitude of the magnetic signal detected by the magnetism detection unit is equal to or smaller than a certain value (22); and
synchronizing the clock signal with the timing(23).

2. The clock extraction method for a patterned medium according to claim 1,
detecting a timing at which an amplitude of said magnetic signal indicates a value within a certain range with zero at the center thereof as said timing at which an absolute value of said amplitude indicates a certain value or smaller(22).

3. A clock extraction method for extracting a clock signal determining a timing of writing or reading data to or from a patterned medium, comprising:
detecting by using a magnetism detection unit a magnetic signal recorded in the patterned medium arraying magnetic dots at certain intervals for recording the magnetic signal;
detecting a zero-cross point at which an amplitude of the magnetic signal detected by the magnetism detection unit changes from the positive to negative, or from the negative to positive(52); and
synchronizing the clock signal with the zero-cross point (21).

4. The clock extraction method for a patterned medium according to claim 3,
supplying a phase locked loop (PLL) circuit generating said clock signal with a zero-cross detection signal indicating said zero-cross point as a reference signal, and synchronizing the clock signal with the zero-cross detection signal.

5. The clock extraction method for the patterned medium according to claim 1,
setting a wavelength of said clock signal equal to a center distance of said magnetic dots.

6. The clock extraction method for the patterned medium according to claim 3,
setting a wavelength of said clock signal equal to a center distance of said magnetic dots.

7. A clock extraction circuit for a patterned medium comprising:
a clock signal generation circuit(23) for generating a clock signal determining a timing of writing or reading data to or from the patterned medium;
a magnetism detection unit for detecting a magnetic signal recorded in a patterned medium arraying magnetic dots at certain intervals for recording the magnetic signal; and
a zero level detection circuit (22) for detecting a zero level at which an absolute value of an amplitude of the magnetic signal detected by the magnetism detection unit indicates a certain value or smaller, wherein
the clock signal is synchronized with the timing of the zero level being detected.

8. The clock extraction circuit for the patterned medium according to claim 7, wherein
said zero level detection circuit(22) comprises a first comparator (32) for judging whether or not an amplitude of said magnetic signal is equal to or smaller than a positive reference value, a second comparator (33) for judging whether or not the amplitude of the magnetic signal is equal to or larger than a negative reference value, and an output circuit(34) for outputting a zero level detection signal to said clock signal generation circuit if the first and second comparators (32, 33) respectively judge that the amplitude is equal to or smaller than the positive reference value and also equal to or larger than the negative reference value.

9. A clock extraction circuit for a patterned medium comprising:
a clock signal generation circuit(23) for generating a clock signal determining a timing of writing or reading data to or from a patterned medium;
a magnetism detection unit for detecting a magnetic signal recorded in the patterned medium arraying magnetic dots at certain intervals for recording the magnetic signal; and
a zero-cross detection circuit(52) for detecting a zero-cross point at which an amplitude of the magnetic signal detected by the magnetism detection unit changes from the positive to negative, or from the negative to positive, wherein
the clock signal is synchronized with the zero-cross point.

10. The clock extraction circuit for the patterned medium according to claim 9, wherein
said zero-cross detection circuit(52) comprises a first comparator (54) for detecting whether or not an amplitude of said magnetic signal changes from the positive to negative, a first signal generation circuit (56) for generating a signal triggered by an output signal of the first comparator (54), a second comparator (53) for detecting whether or not the amplitude of the magnetic signal changes from the negative to positive, a second signal generation circuit (55) for generating a signal triggered by an output signal of the second comparator (53), and an output circuit(57) for outputting, to said clock signal generation circuit(23), the output signal of the first signal generation circuit (56) and that of the second signal generation circuit (55) as the zero-cross detection signals indicating said zero-cross point.

11. The clock extraction circuit for the patterned medium according to claim 8, wherein
said clock signal generation circuit(23) is a phase locked loop (PLL) circuit comprising at least a voltage-controlled oscillator (41), a division circuit (42) and a phase comparator(43), wherein
the phase comparator (43) supplies the voltage-controlled oscillator (41) with a control voltage in accordance with a phase difference between said zero level detection signal or zero-cross detection signal and said clock signal, and synchronize the clock signal with the zero level detection signal or zero-cross detection signal.

12. The clock extraction circuit for the patterned medium according to claim 10, wherein
said clock signal generation circuit(23) is a phase locked loop (PLL) circuit comprising at least a voltage-controlled oscillator(41), a division circuit(42) and a phase comparator(43), wherein
the phase comparator (43) supplies the voltage-controlled oscillator (41) with a control voltage in accordance with a phase difference between said zero level detection signal or zero-cross detection signal and said clock signal, and synchronize the clock signal with the zero level detection signal or zero-cross detection signal.

13. A magnetic disk apparatus, comprising:
a clock signal generation circuit (23) for generating a clock signal determining a timing of writing or reading data to or from a patterned medium;
a magnetism detection unit for detecting a magnetic signal recorded in a patterned medium arraying magnetic dots at certain intervals for recording the magnetic signal; and
a zero level detection circuit(22) for detecting a zero level at which an absolute value of an amplitude of the magnetic signal detected by the magnetism detection unit indicates a certain value or smaller, wherein
the clock signal is synchronized with the timing of the zero level being detected.

14. The magnetic disk apparatus according to claim 13, wherein
said zero level detection circuit(22) comprises a first comparator(32) for judging whether or not an amplitude of said magnetic signal is equal to or smaller than a positive reference value, a second comparator.(33) for judging whether or not the amplitude of the magnetic signal is equal to or larger than a negative reference value, and an output circuit(34) for outputting a zero level detection signal to said clock signal generation circuit(23) if the first and second comparators(32,33) respectively judge that the amplitude is equal to or smaller than the positive reference value and also equal to or larger than the negative reference value.

15. A magnetic disk apparatus, comprising:
a clock signal generation circuit (23) for generating a clock signal determining a timing of writing or reading data to or from a patterned medium;
a magnetism detection unit for detecting a magnetic signal recorded in a patterned medium arraying magnetic dots at certain intervals for recording the magnetic signal;
a zero-cross detection circuit(52) for detecting a zero-cross point at which an amplitude of the magnetic signal detected by the magnetism detection unit changes from the positive to negative, or from the negative to positive, wherein the clock signal is synchronized with the zero-cross point.

16. The magnetic disk apparatus according to claim 15, wherein
said zero-cross detection circuit(52) comprises a first comparator (54) for detecting whether or not an amplitude of said magnetic signal changes from the positive to negative, a first signal generation circuit (56) for generating a signal triggered by an output signal of the first comparator(54), a second comparator(53) for detecting whether or not the amplitude of the magnetic signal changes from the negative to positive, a second signal generation circuit(55) for generating a signal triggered by an output signal of the second comparator (53), and an output circuit(57) for outputting, to said clock signal generation circuit(23), the output signal of the first signal generation circuit (56) and that of the second signal generation circuit (55) as the zero-cross detection signals indicating said zero-cross point.

17. The magnetic disk apparatus according to claim 16, wherein
said clock signal generation circuit(23) is a phase locked loop (PLL) circuit comprising at least a voltage-controlled oscillator(41), a division circuit(42) and a phase comparator(43), wherein the phase comparator (43) supplies the voltage-controlled oscillator with a control voltage in accordance with a phase difference between said zero level detection signal or zero-cross detection signal and said clock signal, and synchronize the clock signal with the zero level detection signal or zero-cross detection signal.
